# EUROPEAN PATENT APPLICATION

(11) **EP 1 376 673 A2**
(43) Date of publication of application: **02.01.2004**
(21) Application number: 03250712.1
(22) Date of filing: 04.02.2003
(51) Int. Cl.: H01L 21/3213, H01L 21/02

(54) **Semiconductor device manufacturing method**

(30) Priority: 20.06.2002 JP 2002180453
(71) Applicant: FUJITSU LIMITED, Kawasaki-shi, Kanagawa 211-8588 (JP)
(72) Inventor: Okita, Yoichi, c/o Fujitsu Limited, Kawasaki-shi, Kanagawa 211-8588 (JP)
(74) Representative: Fenlon, Christine Lesley

(57) **Abstract**

A semiconductor device manufacturing method comprises the steps of forming a first conductive film (13), a ferroelectric film (14), and a second conductive film (15) on an insulating film (8), forming a hard mask (18a) on the second conductive film (15), forming a capacitor upper electrode by etching the second conductive film (15) in an area exposed from the hard mask (18a) at a first temperature, forming a capacitor dielectric film by etching the ferroelectric film (14) in the area exposed from the hard mask (18a) at a second temperature, and forming a capacitor lower electrode by etching the first conductive film (13) in the area exposed from the hard mask (18a) at a third temperature that is higher than the second temperature.

## Description

The present invention relates to a semiconductor device manufacturing method and, more particularly, a semiconductor device manufacturing method having the step of forming a capacitor that employs a ferroelectric substance.

In a semiconductor memory, increase in the memory capacity and miniaturization of the device are required. In FeRAM, for the purpose of miniaturization, a memory cell using the stacked ferroelectric capacitor is required.

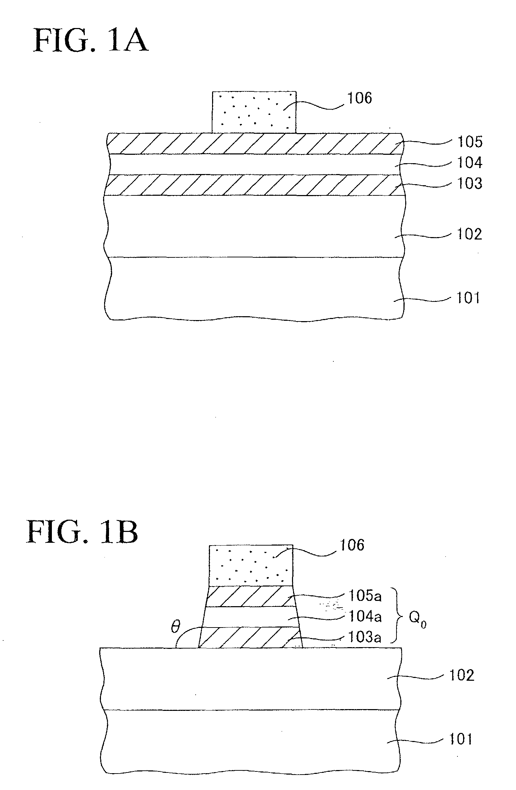

Next, a method of forming the ferroelectric capacitor is explained with reference to FIGS.1A and 1B of the accompanying drawings as follows.

First, as shown in FIG.1A, a first metal film 103, a ferroelectric film 104, and a second metal film 105 are formed sequentially on an insulating film 102 that covers a semiconductor substrate 101, and then a mask 106 having a capacitor planar shape is formed on the second metal film 105.

Then, as shown in FIG.1B, regions of the second metal film 105, the ferroelectric film 104, and the first metal film 103, which are not covered with the mask 106, are etched successively. Accordingly, an upper electrode 105a of a capacitor Qₒ is formed from the second metal film 105 under the mask 106, a dielectric film 104a of the capacitor Qₒ is formed from the ferroelectric film 104, and a lower electrode 103a of the capacitor Qₒ is formed from the first metal film 103.

In this case, the method of forming the stacked ferroelectric capacitor is set forth in Patent Application Publication (KOKAI) Hei 8-45905, for example.

In order to enhance an area efficiency of the capacitance of the capacitor Qₒ, respective planar surfaces of the lower electrode 103a, the dielectric film 104a, and the upper electrode 105a must be set as equal in size as possible by increasing a taper angle θ of a side surface of the capacitor Qₒ to an upper surface of the insulating film 102 as large as possible.

In order to form side surfaces of the capacitor sharply, it is necessary that the etching by-product, which is generated in etching the first metal film 103, the ferroelectric film 104, and the second metal film 105, should be hardly adhered onto the side surfaces of the capacitor Qₒ.

As the method of suppressing the adhesion of the etching by-product onto the side surfaces of the capacitor Qₒ, it is studied to etch films from the second metal film 105 to the first metal film 103 successively while keeping the semiconductor substrate 101 at a high temperature of 300 to 500 °C.

However, if a resist is employed as the material of the mask 106, such a resist is deteriorated in the midst of the etching and does not function as the mask 106.

Therefore, the mask must be formed of material with heat resistance. As the mask with such heat resistance, employment of a hard mask that is made of a hard film such as a titanium film, a titanium nitride film, an aluminum film, or the like may be considered.

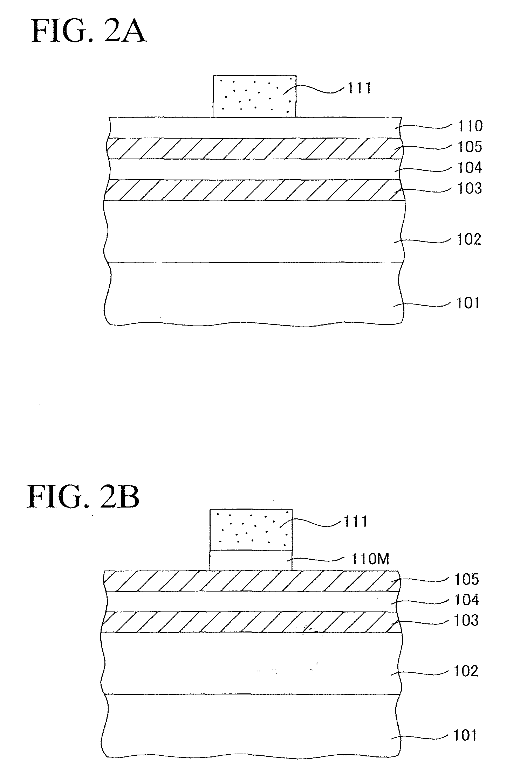

Next, steps of forming the hard mask and forming the capacitor by using the hard mask are explained with reference to FIGS.2A to 2D of the accompanying drawings as follows.

First, as shown in FIG.2A, the first metal film 103, the ferroelectric film 104, and the second metal film 105 are formed sequentially on the insulating film 102. Then, a hard film 110 made of any of titanium, titanium nitride, and aluminum is formed on the second metal film 105. Then, a resist pattern 111 having a capacitor planar shape is formed on the hard film 110.

Then, as shown in FIG.2B, the hard film 110 left under the resist pattern 111 is formed into a hard mask 110M by etching the hard film 110 that is exposed from the resist pattern 111.

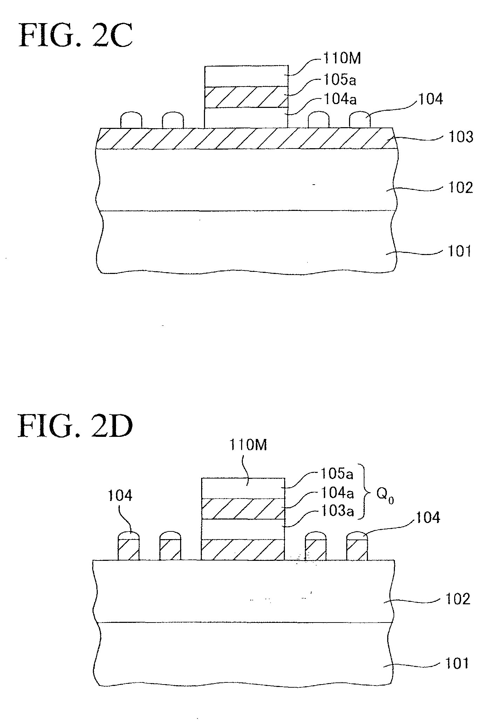

Then, the resist pattern 111 is removed. Then, as shown in FIGS.2C and 2D, regions of the second metal film 105, the ferroelectric film 104, and the first metal film 103, which are not covered with the hard mask 110M, are etched successively. Accordingly, the capacitor Qₒ is formed under the hard mask 110M.

In the event that any of titanium, titanium nitride, and aluminum is employed as the material of the hard mask 110M, etching resistance of the hard mask 110M is improved extremely by condition of which an oxygen gas is added into the etching gas. Therefore, there is no need to form the hard mask 110M thick. In addition, in the event that the resist pattern 111 used to form the hard mask 110M is made of a resist for excimer exposure, it is indispensable that, in order to enhance the pattern precision, the hard film 110 should be formed thin.

However, as shown in FIG.2C, according to an experiment by the inventors of the present invention, it was apparent that, when high-selectivity etching executed at a high temperature in the oxygen-added atmosphere is employed, the microloading effect is enhanced in the step of etching the ferroelectric film 104, in particular the PZT film, by using the hard mask 110M, so that the etching rate of the ferroelectric film 104 is lowered extremely in the narrow region between the capacitors Qₒ and thus residue of the ferroelectric film 104 is generated around the hard mask 110M.

If the etching of the first metal film 103 is carried out in the situation that the residue of PZT is present, the first metal film 103 is left like an island, as shown in FIG.2D, since the residue of the ferroelectric film 104 functions substantially as a mask. As a result, it is possible that the pattern precision of the capacitor Qₒ is lowered or the upper electrodes 105a of the neighboring capacitors Qₒ are shortcircuited by the conductive residue.

Therefore, it may be considered that the hard mask made of a material that does not cause the microloading effect in etching the ferroelectric film should be employed. As such material, there are silicon oxide, silicon nitride, etc. In this case, since the silicon oxide film and the silicon nitride film have low etching selectivity to the etching of the first metal film 103, the ferroelectric film 104, and the second metal film 105, the film thickness must be formed thick in excess of 1 µm. In this case, it is set forth in Patent Application Publication (KOKAI) 2001-36024, for example, that the hard mask 110M is made of silicon nitride.

In contrast, as set forth in Patent Application Publication (KOKAI) Hei 11-354510, the hard mask having a double-layered structure in which the silicon oxide film is formed on the titanium nitride film may be employed.

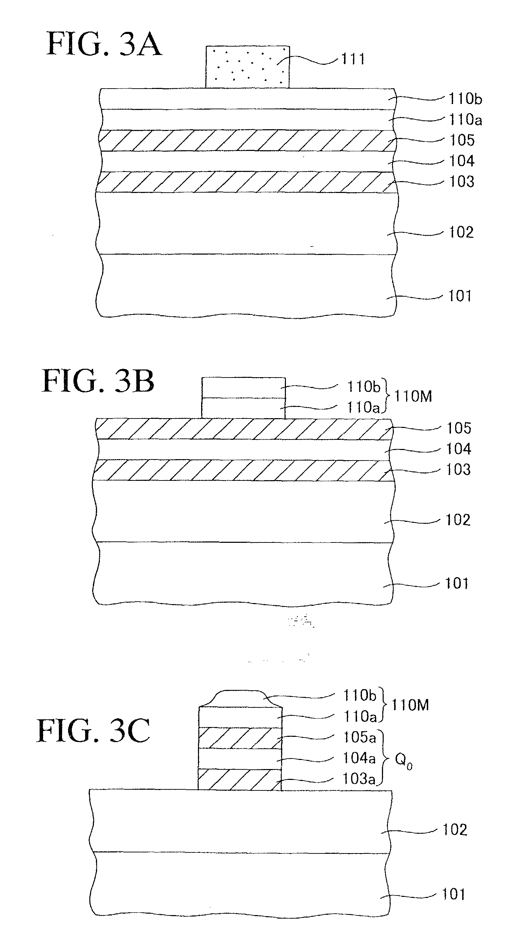

Next, steps of forming the capacitor by employing the hard mask having the double-layered structure will be explained with reference to FIGS.3A to 3C of the accompanying drawings hereunder.

First, as shown in FIG.3A, the first metal film 103, the ferroelectric film 104, and the second metal film 105 are formed sequentially on the insulating film 102. Then, a titanium nitride film 110a and a silicon oxide film 110b are formed on the second metal film 105. Then, a resist pattern 111 having the capacitor planar shape is formed on the silicon oxide film 110b.

Then, as shown in FIG.3B, the silicon oxide film 110b and the titanium nitride film 110a exposed from the resist pattern 111 are etched. Then, the silicon oxide film 110b and the titanium nitride film flea left under the resist pattern 111 are used as the hard mask 110M.

Then, the resist pattern 111 is removed. Then, as shown in FIG.3C, regions of the second metal film 105, the ferroelectric film 104, and the first metal film 103, which are not covered with the hard mask 110M, are successively etched. Accordingly, the capacitor Qₒ is formed under the hard mask 110M.

In case the hard mask 110M having the above-mentioned double-layered structure is employed, the microloading effect is suppressed and thus etching residue of the ferroelectric film 104 is hard to occur, and in addition at least the titanium nitride film 110a is left as the hard mask 110M upon etching the first metal film 103 and thus the gradient of the side surfaces of the capacitor is set steeply.

However, when the hard mask having the structure shown in FIG.3B is employed, not only the film forming step of forming the hard mask is increased but also the etching of the silicon oxide film is not suppressed if oxygen is added in etching. Therefore, the silicon oxide film must be formed thick like about 1µm, for example. Since it is difficult to pattern such silicon oxide film having a thick film thickness by using a resist for excimer exposure, it is hard to form the hard mask with high precision.

As a result, the advantages of the hard mask having the double-layered structure as described above are not sufficiently put into practical use.

Accordingly, it is desirable to provide a semiconductor device manufacturing method including the step that makes it possible to pattern a plurality of films constituting a capacitor with good precision by using hard masks.

According to an embodiment of one aspect of the present invention, there is provided a method of manufacturing a semiconductor device comprising the steps of: forming an insulating film over a semiconductor substrate; forming a first conductive film on the insulating film; forming a ferroelectric film on the first conductive film; forming a second conductive film on the ferroelectric film; forming a hard mask on the second conductive film; forming a capacitor upper electrode under the hard mask by etching the second conductive film in an area, which is exposed from the hard mask, at a first temperature by using a first etching gas; forming a capacitor dielectric film under the hard mask by etching the ferroelectric film in the area, which is exposed from the hard mask, at a second temperature by using a second etching gas; and forming a capacitor lower electrode under the hard mask by etching the first conductive film in the area, which is exposed from the hard mask, at a third temperature that is higher than the second temperature by using a third etching gas.

According to an embodiment of the present invention, in the step of forming the capacitor over the substrate, the substrate temperature at the time of etching of the ferroelectric film is set lower than the substrate temperature at the time of etching of the first conductive film when the first conductive film constituting the capacitor lower electrode, the ferroelectric film constituting the capacitor dielectric film, and the second conductive film constituting the capacitor upper electrode are etched sequentially by using the same hard mask. More particularly, the substrate temperature at the time of etching of the ferroelectric film is set to below 300 °C, e.g., the atmospheric temperature, whereas the substrate temperature at the time of etching of the first conductive film is set to more than 300 °C.

According to an embodiment of the present invention, the microloading effect is hard to occur because the substrate temperature is lowered when the ferroelectric film is to be etched by using the hard mask, and thus generation of the etching residue of the ferroelectric film is prevented. In this case, if the substrate temperature is set too low, it is possible that the taper angle of the side surface of the capacitor dielectric film becomes small, but the substrate temperature is set high when the first conductive film is to be etched subsequently. Therefore, since side walls of the capacitor dielectric film extruding from the hard mask are also etched at the time of etching of the first conductive film, the taper angle of the side surface of the capacitor dielectric film becomes steep finally.

The hard mask is formed by material, the etching resistance of which can be improved by adding oxygen into the etching gas, for example, titanium, titanium nitride, or aluminum. Accordingly, the selective etching ratios of the first conductive film, the ferroelectric film, and the second conductive film to the hard mask are enhanced. Therefore, if the hard mask is formed thin, the first conductive film, the ferroelectric film, and the second conductive film are patterned with good precision. In addition, when the hard mask is formed thin, the patterning precision to form the hard mask is improved and also patterning is facilitated.

By condition of which such hard mask is formed by a single layer, the mask forming step does not become complicated and thus reduction in throughput of the mask forming step is prevented.

Reference will now be made, by way of example, to the accompanying drawings, in which:
FIGS.1A and 1B (as described above) are sectional views of the capacitor forming step in the first previously-proposed manufacturing method described above;
FIGS.2A to 2D (as described above) are sectional views of the capacitor forming step in the second previously-proposed manufacturing method described above;
FIGS.3A to 3C (as described above) are sectional views of the capacitor forming step in the third previously-proposed manufacturing method described above;
FIGS.4A to 4K are sectional views showing semiconductor device forming steps according to an embodiment of the present invention;
FIG.5 is a chart showing control states of the substrate temperature in the etching steps to form a capacitor according to an embodiment of the present invention;
FIG. 6 is a side view showing a capacitor formed according to an embodiment of the present invention; and
FIGS.7A and 7B are schematic configurative views of the reaction chamber of the etching equipment employed in an embodiment of the present invention.

An embodiment of the present invention will be explained with reference to the drawings hereinafter.

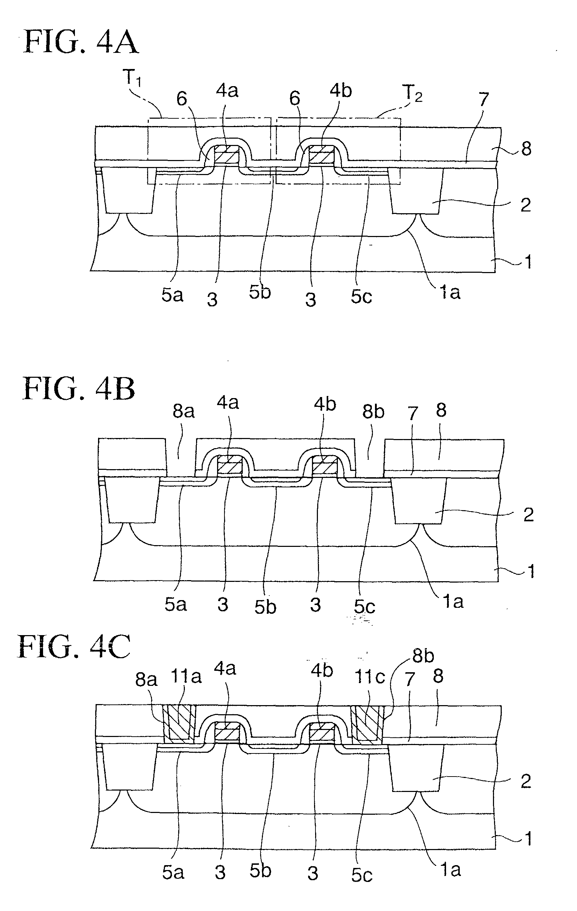

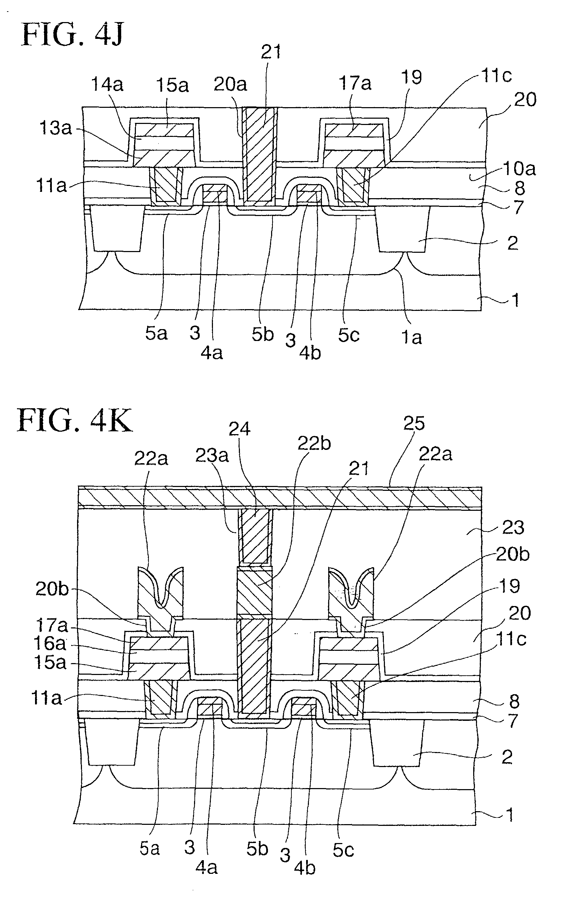

FIGS.4A to 4K are sectional views showing semiconductor device manufacturing steps according to an embodiment of the present invention.

First, steps required until a sectional structure shown in FIG.4A is formed are explained hereunder.

As shown in FIG.4A, an element isolation insulating recess is formed around a transistor forming region of an n-type or p-type silicon (semiconductor) substrate 1 by the photolithography method, and then an element isolation insulating film 2 is formed by burying silicon oxide (SiO₂) in the element isolation insulating recess. The element isolation insulating film 2 having such a structure is called STI (Shallow Trench Isolation). In this case, an insulating film formed by the LOCOS (Local Oxidation of Silicon) method may be employed as the element isolation insulating film.

Then, a p-well 1a is formed by introducing a p-type impurity into the transistor forming region of the silicon substrate 1. Then, a silicon oxide film is formed as a gate insulating film 3 by thermally oxidizing a surface of the transistor forming region of the silicon substrate 1.

Then, an amorphous silicon or polysilicon film and a tungsten silicide film are formed sequentially on the overall upper surface of the silicon substrate 1. Then, gate electrodes 4a, 4b are formed by patterning the silicon film and the tungsten silicide film by virtue of the photolithography method.

In this case, two gate electrodes 4a, 4b are formed in parallel over one p-well 1a. These gate electrodes 4a, 4b constitute a part of the word line.

Then, first to third n-type impurity diffusion regions 5a to 5c serving as the source/drain are formed by ion-implanting an n-type impurity into the p-well 1a on both sides of the gate electrodes 4a, 4b.

Then, an insulating film, e.g., a silicon oxide (SiO₂) film is formed on the entire surface of the silicon substrate 1 by the CVD method. Then, insulating sidewall spacers 6 are left on portions on both sides of the gate electrodes 4a, 4b by etching back the insulating film.

Then, the n-type impurity is ion-implanted into the first to third n-type impurity diffusion regions 5a to 5c once again by using the gate electrodes 4a, 4b and the sidewall spacers 6 as a mask. Thus, the first to third n-type impurity diffusion regions 5a to 5c are formed as an LDD structure.

In this case, the second n-type impurity diffusion region 5b positioned between two gate electrodes 4a, 4b in one transistor forming region is connected electrically to the bit line, described later. The first and third n-type impurity diffusion regions 5a, 5c positioned on both end sides of the transistor forming region are connected electrically to the lower electrode of the capacitor, described later.

According to the above steps, a first MOS transistor T₁ having the gate electrode 4a and the first and second n-type impurity diffusion regions 5a, 5b with the LDD structure and a second MOS transistor T₂ having the gate electrode 4b and the second and third n-type impurity diffusion regions 5b, 5c with the LDD structure are formed on one p-well 1a.

Then, a silicon oxide nitride (SiON) film of about 200 nm thickness is formed as a cover insulating film 7, which covers the MOS transistors T₁, T₂, on the overall surface of the silicon substrate 1 by the plasma CVD method. Then, a silicon oxide (SiO₂) film of about 1.0 µm thickness is formed as a first interlayer insulating film 8 on the cover insulating film 7 by the plasma CVD method using the TEOS gas.

Then, as the densifying process of the first interlayer insulating film 8, such first interlayer insulating film 8 is annealed at a temperature of 700°C for 30 minutes in an atmospheric-pressure nitrogen atmosphere, for example. Then, an upper surface of the first interlayer insulating film 8 is planarized by the CMP (Chemical Mechanical Polishing) method.

Next, steps required until a structure shown in FIG.4B is formed will be explained hereunder.

First, first and second contact holes 8a, 8b are formed on the first and third n-type impurity diffusion regions 5a, 5c by patterning the cover insulating film 7 and the first interlayer insulating film 8 by virtue of the photolithography method.

Then, a Ti film of 30 nm thickness and a TiN film of 50 nm thickness are formed sequentially as a glue film on the upper surface of the first interlayer insulating film 8 and in the first and second contact holes 8a, 8b by the sputter method. Then, a W film is grown on the TiN film by the CVD method to bury insides of the first and second contact holes 8a, 8b perfectly.

Then, as shown in FIG.4C, the W film, the TiN film, and the Ti film are polished by the CMP method to remove them from the upper surface of the first interlayer insulating film 8. The W film, the TiN film, and the Ti film left in the first and second contact holes 8a, 8b are used as first and second conductive plugs 11a, 11c, respectively.

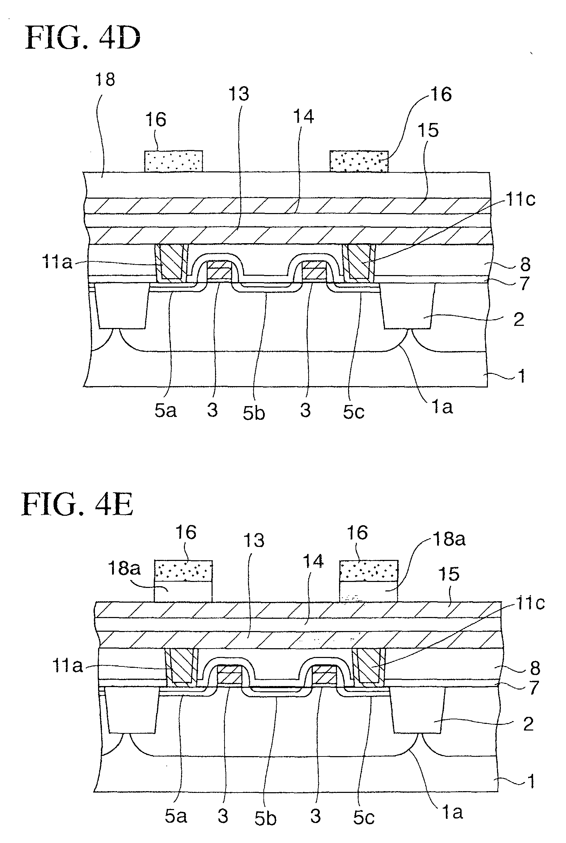

Next, steps required until a structure shown in FIG.4D is formed will be explained hereunder.

First, an iridium (Ir) film, a platinum (Pt) film, a platinum oxide (PtOₓ) film, an iridium oxide (IrOₓ) film, or a strontium ruthenium oxide (SRO) film having a thickness of 300 nm, for example, is formed as a first conductive film 13 on the first and second conductive plugs 11a, 11c and the first interlayer insulating film 8. As the first conductive film 13, a multi-layered structure film selected from the Ir film, the Pt film, the PtOₓ film, and the IrOₓ film may be formed.

In this case, the first interlayer insulating film 8 is annealed to prevent the peeling-off of the film, for example, before or after the first conductive film 13 is formed. As the annealing method, RTA (Rapid Thermal Annealing) executed at 600 to 750°C in an argon atmosphere, for example, is employed.

Then, a PZT film of 100 nm thickness, for example, is formed as a ferroelectric film 14 on the first conductive film 13 by the sputter method. As the method of forming the ferroelectric film 14, there are the MOD (Metal Organic Deposition) method, the MOCVD (Metal Organic CVD) method, the sol-gel method, etc. in addition to this. Also, as the material of the ferroelectric film 14, other PZT material such as PLCSZT, PLZT, etc., the Bi-layered structure compound material such as SrBi₂Ta₂O₉, SrBi₂ (Ta, Nb)₂O₉, etc., and other metal oxide ferroelectric substance in addition to PZT.

Then, the ferroelectric film 14 is annealed in an oxygen atmosphere to crystallize. As such annealing, a two- step RTA process having the first step executed at a substrate temperature of 600°C for a time of 90 seconds in a mixed gas atmosphere consisting of argon and oxygen, and the second step executed at a substrate temperature of 750°C for a time of 60 seconds in an oxygen atmosphere, for example, is employed.

Then, an iridium oxide (IrO₂) film of 200 nm thickness, for example, is formed as a second conductive film 15 on the ferroelectric film 14 by the sputter method.

Then, a hard film 18 made of titanium nitride is formed on the second conductive film 15 to have a thickness of about 300 nm, for example. Material such as titanium, aluminum, or the like, the etching resistance of which is improved by oxygen, as the hard film 18, may be formed in place of the titanium nitride film, otherwise the structure in which these materials are formed as plural layers may be employed.

Then, resist 16 for excimer laser exposure is coated on the hard film 18, and then the resist 16 is exposed by an excimer laser and then developed. Thus, the resist 16 is left over the first and second conductive plugs 11a, 11c to have a capacitor planar shape.

Then, as shown in FIG.4E, the hard film 18 is etched by using the resist 16 as a mask, and thus the hard film 18 left under the resist 16 is used as a hard mask 18a.

The etching of the hard film 18 made of titanium nitride is executed by using the inductively coupled (IPC) plasma etching equipment. As the etching conditions, for example, the silicon substrate 1 is put on the stage in the reaction chamber, BCl₃ and Cl₂ are introduced into the reaction chamber as the etching gas at flow rates of 40 ml/min. and 60 ml/min. respectively, the source power of 13.56 MHz is set to 250 W, the bias power of 400 kHz is set to 200 W, a degree of vacuum in the reaction chamber is set to 1 Pa, and the stage temperature is set to 25°C.

In this case, the bias power is a power of a high- frequency power supply, which is applied to the antenna coil provided to the top portion of the reaction chamber of the IPC plasma etching equipment. Also, the source power is a power of a high-frequency power supply that is connected to the electrostatic chuck fitted to the stage in the reaction chamber.

After the hard mask 18a is formed, the silicon substrate is brought out from the IPC plasma etching equipment and then the resist 16 is removed.

Next, the second conductive film 15, the ferroelectric film 14, and the first conductive film 13 in the regions that are not covered with the hard mask 18a are etched continuously and sequentially.

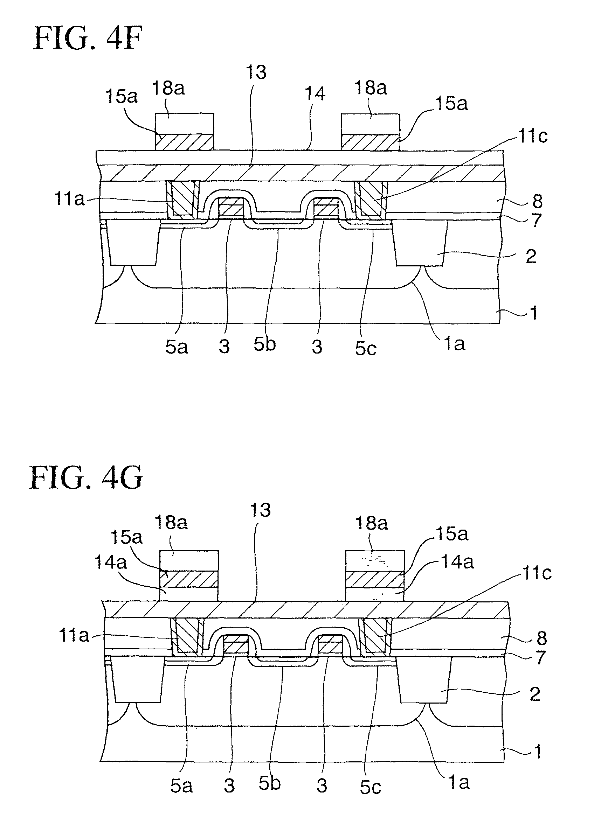

First, as shown in FIG.4F, the region of the second conductive film 15, which is exposed from the hard mask 18a, is etched at a high temperature. Thus, the second conductive film 15 left under the hard mask 18a is used as an upper electrode 15a of the capacitor Q. The etching of the second conductive film 15 is carried out by using the IPC plasma etching equipment. For example, the etching is carried out by putting the silicon substrate 1 on the stage in the reaction chamber, introducing HBr and O₂ into the reaction chamber as the etching gas at flow rates of 10 ml/min. and 40 ml/min. respectively, applying the source power of 800 W at 13.56 MHz, applying the bias power of 700 W at 400 kHz, setting a degree of vacuum in the reaction chamber to 0.4 Pa, and setting the stage temperature to 300 to 500°C, e.g., 400°C.

Then, as shown in FIG.4G, the region of the ferroelectric film 14, which is exposed from the hard mask 18a and the upper electrode 15a, is etched in the state that the stage temperature is set lower than that in the etching of the second conductive film 15. Thus, the ferroelectric film 14 left under the hard mask 18a is used as a dielectric film 14a of the capacitor Q. The etching of the ferroelectric film 14 may be carried out in the reaction chamber of the same IPC plasma etching equipment as the etching of the second conductive film 15 or may be carried out by using another IPC plasma etching equipment. As the etching conditions, for example, Cl₂, Ar, O₂ and CF₄ are introduced into the reaction chamber as the etching gas at flow rates of 10 ml/min., 40 ml/min., 10 ml/min., and 12 ml/min. respectively, the source power of 13.56 MHz is set to 1400 W, the bias power of 400 kHz is set to 800 W, a degree of vacuum in the reaction chamber is set to 0.7 Pa, and the stage temperature is set within the range from the atmospheric temperature to below 300°C, e.g., 25°C. According to such conditions, generation of residue of the ferroelectric film 14 due to the microloading effect is prevented.

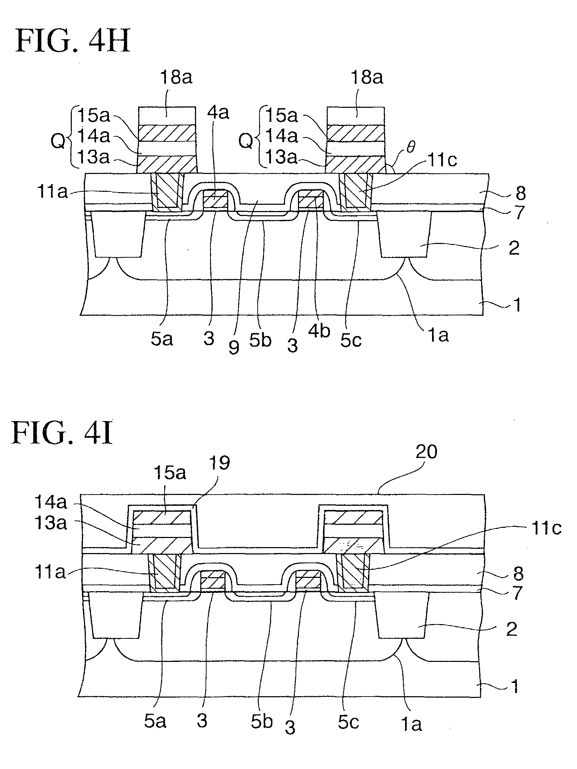

Further, as shown in FIG.4H, the region of the first conductive film 13, which is not covered with the hard mask 18a, is etched in the state that the stage temperature is increased higher than that in the etching of the ferroelectric film 14. Thus, the first conductive film 13 left under the hard mask 18a is used as a lower electrode 13a of the capacitor Q. The etching of the first conductive film 13 is carried out in the reaction chamber of the same IPC plasma etching equipment as the etching of the second conductive film 15. The etching conditions are given such that, for example, HBr and O₂ are introduced into the reaction chamber as the etching gas at flow rates of 10 ml/min. and 40 ml/min. respectively, the source power of 13.56 MHz is set to 800 W, the bias power of 400 kHz is set to 700 W, a degree of vacuum in the reaction chamber is set to 0.4 Pa, and the stage temperature is set within the range of 300°C to 500°C, e.g., 400°C.

After the etching of the first conductive film 13 is ended, over-etching is carried out by about 60 % in time.

In this case, a pressure in the atmosphere in which the first conductive film 13 and the second conductive film 15 are etched is set lower than that in the atmosphere in which the ferroelectric film 14 is etched.

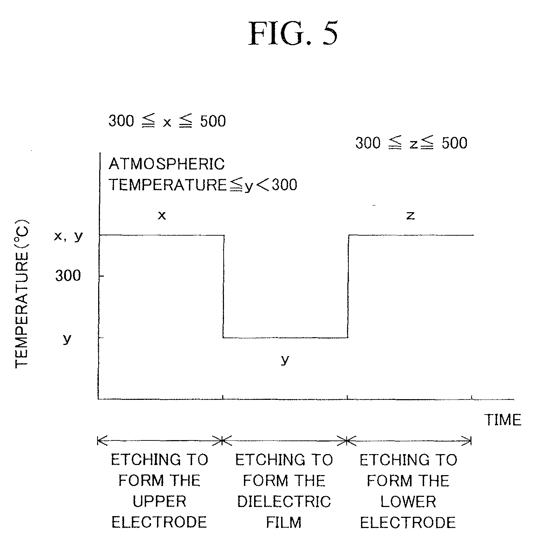

As a result, the step of patterning the capacitor Q consisting of the lower electrode 13a, the dielectric film 14a, and the upper electrode 15a is ended. In this case, changes of the substrate temperature in respective etching steps of the second conductive film 15, the ferroelectric film 14, and the first conductive film 13 are shown in FIG.5.

One lower electrode 13a is connected electrically to the first n-type impurity diffusion region 5a via the first conductive plug 11a over one p-well 1a, while the other lower electrode 13a is connected electrically to the third n-type impurity diffusion region 5c via the second conductive plug 11c. Also, a taper angle θ of the side surfaces of the capacitor Q is about 80 degree.

Then, the hard mask 18a is removed by wet etching or dry etching. As the etchant of the wet etching applied to the hard mask 18a made of titanium nitride, a mixed solution consisting of hydrogen peroxide and ammonia, for example, is employed.

In this case, when the upper portion of the hard mask is formed of silicon oxide, the first interlayer insulating film 8 is etched to remove the silicon oxide and thus a recess is formed in the region between the capacitors Q. However, in the present embodiment, since the hard mask is not formed of the silicon oxide, such problem is not caused.

Then, in order to recover the ferroelectric film 14 from the damage caused by the etching, recover annealing is executed. The recover annealing in this case is executed at a substrate temperature of 650°C for 60 minutes in an oxygen atmosphere, for example.

Then, as shown in FIG.4I, alumina of 50 nm thickness is formed as a capacitor protection insulating film 19 on the first interlayer insulating film 8 and the capacitor Q by the sputter. Then, the capacitor Q is annealed at 650°C for 60 minutes in an oxygen atmosphere. The capacitor protection insulating film 19 protects the capacitor Q from the process damage.

Then, a silicon oxide (SiO₂) film of about 1.0 µm thickness is formed as a second interlayer insulating film 20 on the capacitor protection insulating film 19 by the plasma CVD method using the TEOS gas. Then, an upper surface of the second interlayer insulating film 20 is planarized by the CMP method. In this example, a remaining film thickness of the second interlayer insulating film 20 after CMP is set to about 300 nm on the upper electrode 15a of the capacitor Q.

Next, steps required until a structure shown in FIG.4J is formed is explained hereunder.

First, the second interlayer insulating film 20, the capacitor protection insulating film 19, and the cover insulating film 7 are etched by using a resist mask (not shown). Thus, a hole 20a is formed on the second n-type impurity diffusion region 5b.

Then, a Ti film of 30 nm thickness and a TiN film of 50 nm thickness are formed sequentially as a glue film in the hole 20a and on the second interlayer insulating film 20 by the sputter method. Then, a W film is grown on the glue film by the CVD method to bury perfectly the inside of the hole 20a.

Then, the W film, the TiN film, and the Ti film are polished by the CMP method to remove them from the upper surface of the second interlayer insulating film 20. Then, the W film and the glue film left in the hole 20a is used as a third conductive plug 21. This third conductive plug 21 is connected electrically to the second n-type impurity diffusion region 5a.

Next, steps required until a structure shown in FIG.4K is formed are explained hereunder.

First, a SiON film is formed as a second oxidation preventing film (not shown) on the third conductive plug 21 and the second interlayer insulating film 20 by the CVD method. Then, the second oxidation preventing film (not shown), the second interlayer insulating film 20, and the capacitor protection insulating film 19 are patterned by the photolithography method. Thus, contact holes 20b are formed on the upper electrode 15a of the capacitor Q.

The capacitor Q that is subjected to the damage caused by forming the contact holes 20b is recovered by annealing. This annealing is executed at a temperature of 550°C for 60 minutes in an oxygen atmosphere, for example.

Then, the oxidation preventing film formed on the second interlayer insulating film 20 is removed by etching-back, and also a surface of the third conductive plug 21 is exposed.

Then, a metal film is formed in the contact holes 20b on the upper electrodes 15a of the capacitors Q and on the second interlayer insulating film 20. Then, first-layer metal wirings 22a, which are connected to the upper electrodes 15a via the contact holes 20b, and a conductive pad 22b, which is connected to the third conductive plug 21, are formed by patterning the metal film. As the layered metal film, a multi-layered structure constructed by forming sequentially a Ti film of 60 nm thickness, a TiN film of 30 nm thickness, an Al-Cu film of 400 nm thickness, a Ti film of 5 nm thickness, and a TiN film of 70 nm thickness, for example, is employed.

In this case, as the method of patterning the metal film, the method of forming a reflection preventing film on the metal film, then coating resist on the reflection preventing film, then forming resist patterns having a wiring shape, etc. by exposing/developing the resist, and then etching the reflection preventing film and the metal film by using the resist patterns is employed.

Then, a third interlayer insulating film 23 is formed on the second interlayer insulating film 20, the first-layer metal wirings 22a, and the conductive pad 22b. Then, a hole 23a is formed on the conductive pad 22b by patterning the third interlayer insulating film 23. Then, a fourth conductive plug 24 made of a TiN film and a W film sequentially from the bottom is formed in the hole 23a.

Then, a metal film is formed on the third interlayer insulating film 23. Then, a bit line 25 connected to the fourth conductive plug 24 is formed by patterning this metal film by means of the photolithography method. The bit line 25 is connected electrically to the second n-type impurity diffusion region 5b via the fourth conductive plug 24, the conductive pad 22b, and the third conductive plug 21. Subsequently to this, an insulating film for covering the second-layer wiring layer, etc. are formed. But their details will be omitted herein.

In the above embodiment, as shown in FIG.5, the substrate temperature applied to the etching of the second conductive film 15 by using the hard masks 18a is set to a high temperature of more than 300°C but less than 500°C. The substrate temperature applied to the etching of the ferroelectric film 14 by using the hard masks 18a is set to a low temperature of more than the atmospheric temperature but below 300°C. The substrate temperature applied to the etching of the first conductive film 13 by using the hard masks 18a is set to a high temperature of more than 300°C but less than 500°C.

Since oxygen gas is added to the etching gas in all etching times, the etching resistance of the hard masks 18a can be enhanced and also the selective etching ratios of the films 13, 14, 15 to the hard masks 18a are increased. For example, in the above etching conditions for forming the capacitor Q, the selective etching ratios of the first conductive film 13 and the second conductive film 15 to the TiN hard masks 18a become infinity, respectively, and thus the hard masks 18a are seldom etched. Then, in the above etching conditions for forming the capacitor Q, the selective etching ratio of the PZT ferroelectric film 14 to the TiN hard masks 18a becomes about 2, and thus the hard masks 18a are never eliminated at the etching time of the ferroelectric film 14.

Also, when the stage temperature is lowered at the time of etching of the ferroelectric film 14, the microloading effect is difficult to occur and thus the etching residue of the ferroelectric substance is not generated around the capacitors Q.

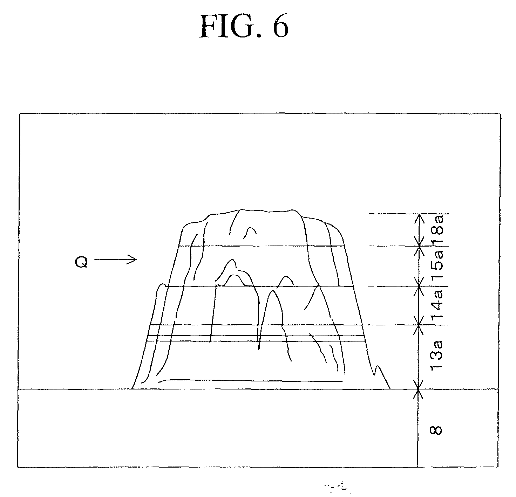

FIG.6 is a side view showing a capacitor that was formed actually by forming the hard masks 18a made of TiN and having a thickness of 300 nm on the second conductive film 15, and then patterning the second conductive film 15, the ferroelectric film 14, and the first conductive film 13 under the above etching conditions. As shown in FIG.6, the etching residue shown in FIG.2D has not been generated on the first interlayer insulating film 8 around the capacitors Q.

In this case, FIG.6 is depicted based on a microphotograph that picks up the image of the side surface of the capacitor, which was formed actually under the above etching conditions. In FIG.6, edge portions of the hard mask 18a are thinner than the center portion thereof since they are etched in etching the ferroelectric film 14.

By the way, in the step of forming the dielectric film 14a of the capacitor Q, since the ferroelectric film 14 is etched at a low temperature, a taper angle of the side surface of the dielectric film 14a does not become so steep. However, the side surface of the dielectric film 14a is etched during when the etching of the first conductive film 13 and, in addition, the over-etching of the first conductive film 13, are carried out at a high temperature, respectively. Thus, finally the taper angle of the side surface of the capacitor Q containing the side surface of the dielectric film 14a becomes large and sharp.

Meanwhile, in the above embodiment, the stage temperature used in the etching of the second conductive film 15 is set to 300 to 500°C. But such etching may be carried out at a low temperature in the range of more than the atmospheric temperature but below 300°C. This is because, in the etching of the second conductive film 15, that is, the initial stage of the capacitor Q forming step, the reaction product is hardly adhered onto the side surface of the upper electrode 15a and thus the taper angle of the side surface of the upper electrode 15a becomes large. In addition, in the step of forming the lower electrode 13a, since the first conductive film 13 is etched at a high temperature, the portion of the upper electrode 15a extruding from the hard mask 18a is etched simultaneously at that time. Thus, the final taper angle of the side surface of the capacitor Q become steep.

The etching conditions of the second conductive film 15 when 25°C is selected as the atmospheric temperature are given such that, for example, Cl₂, Ar, and O₂ are introduced into the reaction chamber as the etching gas at flow rates of 10 ml/min., 40 ml/min., and 10 ml/min. respectively, the source power of 13.56 MHz is set to 1400 W, the bias power of 400 KHz is set to 800 W, and a degree of vacuum in the reaction chamber is set to 0.7 Pa.

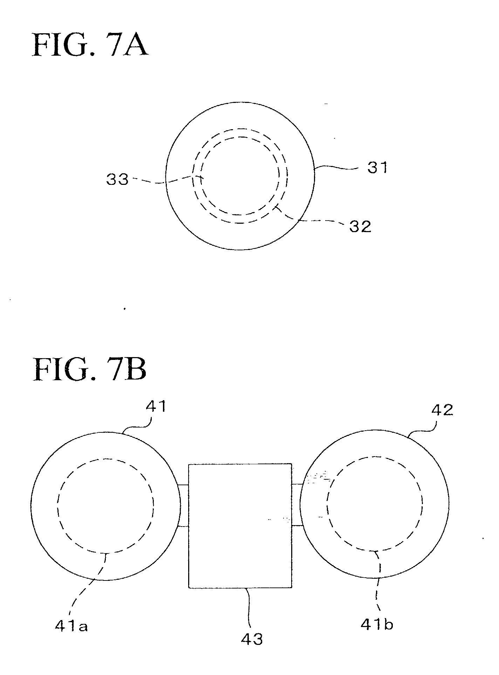

In the meanwhile, as the method of executing the etching in two temperature ranges, any one of the method of executing the etching in one reaction chamber 31 by executing two types of temperature control, as shown in FIG.7A, and the method of executing the etching by controlling separately the temperatures of wafer stages 41a, 41b in two reaction chambers 41, 42, as shown in FIG.7B, may be employed.

In case two types of temperature control is to be executed in the reaction chamber 31 of one etching equipment, the wafer stage 32 with a heating/cooling mechanism 33 may be employed or a lamp heating mechanism (not shown) may be provided, in order to implement two types of temperature control.

Also, in case the ferroelectric film 14 and the first metal film 13 are to be etched separately in respective reaction chambers 41, 42 of two etching equipments, the etching equipment in which two reaction chambers 41, 42 or more are connected via a vacuum transferring chamber 43 may be employed or two stand-alone equipments may be employed.

As described above, according to an embodiment of the present invention, in the step of forming the capacitor over the substrate, the substrate temperature at the time of etching the ferroelectric film is set lower than the substrate temperature at the time of etching the first conductive film when the first conductive film constituting the capacitor lower electrode, the ferroelectric film constituting the capacitor dielectric film, and the second conductive film constituting the capacitor upper electrode are to be etched sequentially by using the same hard masks. Therefore, the microloading effect is hard to occur when the ferroelectric film is etched by using the hard masks, and thus generation of the etching residue of the ferroelectric film can be prevented.

## Claims

1. A manufacturing method of a semiconductor device comprising the steps of:
forming an insulating film (8) over a semiconductor substrate (1);
forming a first conductive film (13) over the insulating film (8);
forming a ferroelectric film (14) on the first conductive film (13);
forming a second conductive film (15) on the ferroelectric film (14);
forming a hard mask (18a) over the second conductive film (15);
forming a capacitor upper electrode (15a) under the hard mask (18a) by etching the second conductive film (15) in an area, which is exposed from the hard mask (18a), at a first temperature by using a first etching gas;
forming a capacitor dielectric film (14a) under the hard mask (18a) by etching the ferroelectric film (14) in the area, which is exposed from the hard mask (18a), at a second temperature by using a second etching gas; and
forming a capacitor lower electrode (13a) under the hard mask (18a) by etching the first conductive film (13) in the area, which is exposed from the hard mask (18a), at a third temperature that is higher than the second temperature by using a third etching gas.

2. A manufacturing method of a semiconductor device according to claim 1, wherein oxygen is contained in the first etching gas, the second etching gas, and the third etching gas, respectively.

3. A manufacturing method of a semiconductor device according to claim 2, wherein a flow rate ratio of the oxygen in the second etching gas is smaller than a flow rate ratio of the oxygen in the first etching gas and a flow rate ratio of the oxygen in the third etching gas.

4. A manufacturing method of a semiconductor device according to any preceding claim, wherein the first temperature is higher than the second temperature.

5. A manufacturing method of a semiconductor device according to any preceding claim, wherein the first temperature is set in a range in which the second temperature is set.

6. A manufacturing method of a semiconductor device according to any preceding claim, wherein the second temperature is set in a range of more than an atmospheric temperature but below 300°C.

7. A manufacturing method of a semiconductor device according to any preceding claim, wherein the third temperature is more than 300°C but less than 500°C.

8. A manufacturing method of a semiconductor device according to any preceding claim, wherein etching of the ferroelectric film (14) exposed from the hard mask (18a) is executed in a first reaction chamber (41), and etching of the first conductive film (13) exposed from the hard mask (18a) is executed in a second reaction chamber (42) that is different from the first reaction chamber (41).

9. A manufacturing method of a semiconductor device according to any preceding claim, wherein each of the second conductive film (15), the ferroelectric film (14), and the first conductive film (13) is etched in the same reaction chamber (31).

10. A manufacturing method of a semiconductor device according to any preceding claim, wherein a pressure in an atmosphere into which the first etching gas and the third etching gas are introduced is lower than a pressure in an atmosphere into which the second etching gas is introduced.

11. A manufacturing method of a semiconductor device according to any preceding claim, wherein a halogen element is contained in the first etching gas, the second etching gas, and the third etching gas.

12. A manufacturing method of a semiconductor device according to claim 11, wherein a first halogen is contained in the first etching gas and the third etching gas, and a second halogen that is different from the first halogen is contained in the second etching gas.

13. A manufacturing method of a semiconductor device according to claim 12, wherein the first halogen is bromine and the second halogen is chlorine.

14. A manufacturing method of a semiconductor device according to any preceding claim, wherein a fluorine atom is contained in the second etching gas.

15. A manufacturing method of a semiconductor device according to any preceding claim, wherein the step of forming the hard mask (18a) includes the steps of,
forming a hard film (18) over the second conductive film (15),
forming a resist pattern (16) having a capacitor planar shape over the hard film (18),
forming the hard mask (18a) by etching the hard film (18) while using the resist pattern (16) as a mask, and
removing the resist pattern (16).

16. A manufacturing method of a semiconductor device according to any preceding claim, wherein the hard mask (18a) is formed of one of titanium, titanium nitride, and aluminum.

17. A manufacturing method of a semiconductor device according to any preceding claim, wherein the hard mask (18a) has a single-layer structure.
